# EUROPEAN PATENT SPECIFICATION

(11) **EP 3 696 519 B1**
(45) Date of publication and mention of the grant of the patent: **13.11.2024**
(21) Application number: 20155747.7
(22) Date of filing: 05.02.2020
(51) Int. Cl.: H01G 2/02, H01G 4/40, H04R 1/44, H04R 19/04, G01H 3/00, G01H 11/06, H01G 4/12

(54) **MINIATURE SENSOR OF ACOUSTIC PRESSURE IN LIQUIDS AND GASES**
MINIATUR-SCHALLDRUCKSENSOR IN FLÜSSIGKEITEN UND GASEN
MINI-CAPTEUR DE PRESSION ACOUSTIQUE DANS LES LIQUIDES ET GAZ

(30) Priority: 13.02.2019 CZ 20190084
(43) Date of publication of application: 19.08.2020
(73) Proprietor: Ceské vysoké ucení technické v Praze, 16000 Praha 6- Dejvice (CZ)
(72) Inventor: PLOCEK, Jaroslav, 15500 Praha 5 - Reporyje (CZ); SIEGER, Ladislav, 14100 Praha 4 (CZ)
(74) Representative: Kratochvil, Vaclav

(56) References cited:
- US-A1- 2008 027 332
- US-A1- 2012 224 726
- US-A1- 2016 134 973
- LEWIN ET AL: "Miniature piezoelectric polymer ultrasonic hydrophone probes", ULTRASONICS, IPC SCIENCE AND TECHNOLOGY PRESS LTD. GUILDFORD, GB, vol. 19, no. 5, 1 September 1981 (1981-09-01), pages 213 - 216, XP025665162, ISSN: 0041-624X, [retrieved on 19810901], DOI: 10.1016/0041-624X(81)90005-6

## Description

### Field of the invention

A miniature sensor of acoustic pressure in liquids and gases is provided, allowing point measurement of acoustic pressure without disturbing the acoustic field by the sensor, in the frequency range of ones to tens of kHz. A multilayer ceramic SMD capacitor with external polarization voltage is used as the sensor element.

### Background of the invention

Acoustic sensors affecting the acoustic field in liquid or gaseous environments by their presence only to a negligible extent, with actual active element dimensions below 1 mm, are currently based on the following three principles.

One of these principles is a piezoelectric sensor with PVDF film. This sensor utilizes the piezoelectric properties of the thermoplastic Polyvinylidene fluoride fluoropolymer. The PVDF film is provided with conductive electrodes on both sides and is placed at the end of a thin metal tube. One of the leads is the tube body, the other lead is the conductor running through the tube cavity. The end of the tube with the film is closed with a contact and shielding layer. Due to the low capacity, high impedance and low sensitivity of the sensor, an amplifier must be used immediately after the connecting cable. The deformation of the PVDF film by the acoustic pressure produces an electrical signal on the electrodes, proportional to the time course and the amount of deformation. The smallest feasible sensors of this type have a diameter 0.5 mm with a foil thickness of 9 µm and can be used in the frequency range of approx. 1-100 MHz.

For applications in the frequency range of ones to tens of kHz, this sensor family has the following disadvantages. The sensors have low sensitivity and strong imbalance of the frequency characteristics. The high impedance of the signal source due to the low capacitance of the sensing element causes its higher susceptibility to electromagnetic interference. The implementation of these sensors is demanding both technically and financially.

More detailed information on this sensor family can be found in the following articles and patents.
DeReggi, A.S., Roth, S.C., Kenney, J.M., Edelman, S. and Harris, G.R. Piezoelectric polymer probe for ultrasonic applications J Acoust Soc Am (1981) 69 853-859
US4433400A, US4517665A belong to this article.
Shotton, K.C., Bacon, D.R. and Quilliam, R.M. A PVDF membrane hydrophone for operation in the range 0.5 MHz to 15 MHz Ultrasonics (1980) 18 123-126
Lewin, P.A., Schafer, M. and Gilmore, J.M. Miniature piezoelectric polymer ultrasonic hydrophone probes Ultrasonics (1981) 19 213-216
Bacon, D.R. Characteristics of a PVDF membrane hydrophone for use in the range 1-100 MHz IEEE Trans Sonics Ultrason (1982) 29 18-25
Preston, R.C., Bacon, D.R., Livett, A.J. and Rajendran, K. PVDF membrane hydrophone performance properties and their relevance to the measurement of the acoustic output of medical ultrasonic equipment J Phys E. Sci Instrum (1983) 16 786-796
Platte, M. A Polyvinylidene fluoride needle hydrophone for ultrasonic applications Ultrasonics (1985) 23 113-118
US2008027332 (BRADLEY ALISTAIR D [US]) 31 January 2008
US2012224726 (PAHL WOLFGANG [DE], et al) 6 September 2012
US2016134973 (OLIAEI OMID [US], et al) 12 May 2016

For example, US4316115A relates to the said sensor type.

The second family are piezoelectric sensors with thin-film polycrystalline ceramics. In this type of sensor, a layer of piezo-ceramic material is applied to the face of the metal substrate, such as a titanium wire with a diameter of 0.6 mm, using a special process, which is then provided with another conductive electrode. The wire with the piezo-ceramic layer is connected to the inner conductor of the lead coaxial cable. It is first provided with an insulating layer on the sides, and then with a closing contact and shielding layer, which is connected to the sheathing of the lead coaxial cable. The deformation of the piezo-ceramic layer by the acoustic pressure produces an electrical signal on its electrodes, proportional to the time course and the amount of deformation. The resulting miniature sensor can be used in a wide frequency range from ones to 100 MHz.

For applications in the frequency range of ones to tens of kHz, this family has the following disadvantages. The sensors show low sensitivity and strong imbalance of the frequency characteristics. The high impedance of the signal source due to the rather low capacitance of the sensing element causes its higher susceptibility to electromagnetic interference. This sensor type is also demanding both technically and financially.

This sensor type is described, for example, in JP2005089229A or in the article Development of Miniature Needle-Type Hydrophone with Lead Zirconate Titanate Polycrystalline Film Deposited by Hydrothermal Method, Hiroshi KITSUNAI, Norimichi KAWASHIMA, Shinichi TAKEUCHI, Mutsuo ISHIKAWA, Minoru KUROSAWA and Etsuzo ODAIRA, Japanese Journal of Applied Physics, Vol. 45, No. 5B, 2006, pp. 4688-4692.

The third family consists of an optoelectrical sensor with fiber optic. One of its subfamilies is a reflective sensor, which consists of a glass optic fiber immersed with one end in the liquid in which the acoustic pressure is measured. Light of suitable wavelength is introduced into the fiber. The amount of light reflected off the fiber end depends on the refraction index of the liquid. The refraction index depends on the density of the liquid, which is influenced by the acoustic pressure. At the other end of the fiber, the reflected light is converted to an electrical signal proportional to the acoustic pressure. Reflective sensors are further enhanced by use of layers of different materials at the sensing end of the fiber to increase light reflection and its dependence on acoustic pressure. The advantage of this sensor is its insensitivity to electromagnetic interference. Its disadvantage is very low sensitivity, usability only in liquids and extreme technical and financial demands.

Such sensor is described, for example, in the article Staudenraus J. and Eisenmenger W., Fibre-optic probe hydrophone for ultrasonic and shock-wave measurements in water, Ultrasonics, vol 31., No 4., pp267-273, 1993 or in US 5,010,248.

The second sub-family of fiber optic optoelectrical sensors is the Fabry-Pérot sensor. Here, an interferometric cell is formed on the fiber face by applying another optically permeable layer terminated by a mirror surface. The deformation, here the change in length of the cell due to acoustic pressure, creates phase changes of the coherent light wave that returns through the fiber after passing through the cell. A connected optoelectronic device converts these phase changes to an electrical signal. The advantage is a significantly higher sensitivity compared to the reflective sensor as well as the ability to work with lower frequencies in the order of tens of kHz and, same as with the reflective sensor, the insensitivity to electromagnetic interference. The disadvantage is lower sensitivity, usability only in liquids and also, same as with the reflective type, extreme technical and financial demands.

For example, US5311485A, DE19541952A1 relate to this type of sensors. The literature describes them in the following publications: Morris et al.: The Fabry-Pérot fiber-optic hydrophone, J. Acoust. Soc. Am., Vol. 125, No. 6, June 2009, or in the article JINYU MA, MEIRONG ZHAO, XINJING HUANG, HYUNGDAE BAE, YONGYAO CHEN, AND MIAO YU, Low cost, high performance white-light fiberoptic hydrophone system with a trackable working point, OPTICS EXPRESS 19008, Vol. 24, No. 17 | 22 Aug 2016.

### Summary of the invention

The above-mentioned disadvantages are overcome by the miniature sensor of acoustic pressure in liquids and gases according to the present invention. The invention provides a system according to claim 1.

The advantage of this arrangement of an acoustic sensor of pressure in liquids and gases is the ability to function in liquids and gases at frequencies of the order of tens of kHz with small own dimensions. Thus, the presence of the sensor does not disturb the examined acoustic fields. Another advantage is the low impedance of the signal source itself, i.e. a capacitor with a capacity of the order of ones of micro Farads, creating an increased immunity to electromagnetic interference and reducing the requirements on the input impedance of the connected evaluation device. A significant advantage is the possibility of separate evaluation of interfering signals and the wanted signal associated with interference by switching off the polarization voltage. The low financial and technological demands on implementation of this sensor are also significant.

### Brief description of the Drawings

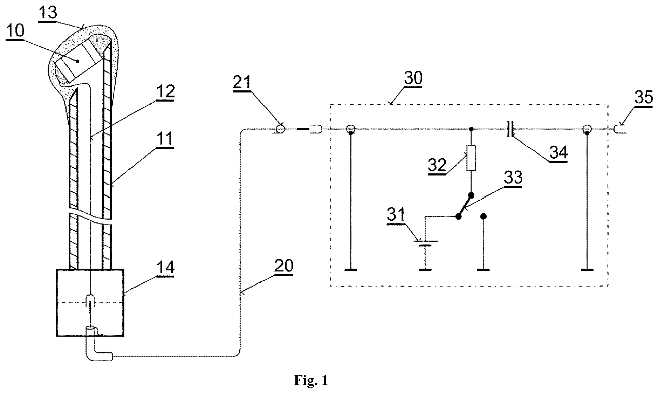

An example of the arrangement of the miniature sensor of acoustic pressure in liquids and gases according to the invention is shown schematically in the attached drawing.

### Example embodiment of the invention

The miniature sensor of acoustic pressure in liquids and gases shown in the attached drawing consists of a multilayer ceramic SMD capacitor 10, in the embodiment of the invention a 0402 SMD capacitor (having surface dimensions of 1 × 0.5 mm) is used with capacitance of 2.2 µF, voltage of 35 V placed at the tip of a hollow metal needle 11 with outer diameter of 0.45 mm and length of 80 mm. One lead of the SMD capacitor 10 is conductively connected to the needle 11 and the other lead of the SMD capacitor 10 is connected to the connection lead 12 running through the cavity of the needle 11. The tip of the needle 11 with the SMD capacitor 10 and the connection lead 12 is coated with a thin impermeable insulation layer 13. This layer must be as thin as possible in order not to block passage of acoustic waves and at the same time to be able to reliably electrically isolate the SMD capacitor 10 from the liquid in which the sensor may be used. The other end of the needle 11 is fitted with a miniature connector 14 for connecting a thin coaxial connecting cable 20. The coaxial connection cable 20 is connected via an additional connector 21 to an electrically shielded adapter 30, containing a miniature battery 31 serving as a source of the 35 V polarization voltage, decoupling resistor 32, a polarization voltage switch 33 and the decoupling output capacitor 34. The adapter 30 is provided with an output BNC connector 35, allowing connection to a subsequent device selected according to the sensor application. This may be a measuring or display device such as an AC voltmeter, an oscilloscope, a converter with a computer and a recording or evaluation device, and the like.

Since any connection of an external source introduces interference signals into the system, the polarization voltage source must be enclosed in a shielded adapter 30 and its dimensions should be as small as possible to reduce induction from magnetic fields, so that the closed loop containing the polarization voltage source is as small as possible. For example, an existing sensor has a sensitivity of about 20 nV/Pa in the 20-30 kHz range, so that the processed signals are in the microvolts to millivolts range and therefore a reasonable signal/noise + interference ratio must be maintained. The size of the polarization voltage of battery 31 is limited from above by the permissible voltage of the usable SMD capacitor 10. The SMD capacitor 10 is selected with the smallest possible embodiment allowed by the technology, and at the same time with the maxim capacity and the maximum operating voltage. A SMD capacitor 10 with the above-mentioned values seems to be a compromise according to the current technological possibilities.

The acoustic pressure in the environment in which the sensor is placed, i.e. in the liquid or gaseous environment, causes time-varying deformations of the multilayer ceramic SMD capacitor 10. These deformations influence its capacity. With polarization voltage attached, an alternating voltage appears on the SMD capacitor10, proportional to its deformation and therefore also the time course of the acoustic pressure. This signal is monitored and evaluated as required with a device connected to the sensor via the output BNC connector 35.

The polarization voltage switch 33 of the miniature battery 31 allows deactivation of the sensor and, at the same time, distinguishing the interfering signals from the wanted signal invoked by the acoustic pressure.

### Industrial applicability

The said miniature sensor of acoustic pressure in liquids and gases is applicable in the development and manufacture of systems operating with an intense acoustic field in both the ultrasonic and audible ranges, such as washing machines, cleaners, separation devices, and detection and imaging systems.

## Claims

1. A system configured to execute a point measurement of acoustic pressure in liquids and gases, comprising:
a metal hollow needle (11), comprising an apex;
a miniature sensor, consisting of a multilayer ceramic SMD capacitor (10);
a miniature connector (14) placed at an extremity of the metal hollow needle (11) opposite to the apex;
a thin coaxial cable (20);
an electrically shielded adapter (30) consisting of:
an input connector (21);
a decoupling resistor (32);
an output decoupling capacitor (34);
an output BNC connector (35) configured to be connected to a measuring,
recording or evaluation device selected according to the application used;
a miniature battery (31); and
a switch (33)
wherein one end of the output decoupling capacitor (34) is connected to the input connector (21) and the other end is connected to the output BNC connector (35);
wherein one end of the output decoupling resistor (32) is connected to the one end of the output decoupling capacitor (34) and the other end is connected to a common pole of the switch (33);
wherein one pole of the switch (33) is connected to the positive pole of the miniature battery (31) and the other pole is connected to a ground terminal;
wherein the negative pole of the miniature battery (31) is grounded; and
wherein the thin coaxial cable (20) is configured to be connected with the miniature connector (14) and the input connector (21) of the adapter;
wherein one lead of the SMD capacitor (10) is conductively connected to the needle (11) and the other lead of the SMD capacitor (10) is connected to a conductor (12) running through the cavity of needle (11);
wherein the apex of the needle (11), the SMD capacitor (10) and the connecting conductor (12) are coated with a thin impermeable electrical insulating layer (13);
wherein the extremity of the hollow needle (11) opposite to the apex and the conductor (12) are connected to the thin coaxial connecting cable (20); and
wherein the thin coaxial connecting cable (20) is configured to transmit a signal from the miniature sensor for further processing and to supply a necessary DC bias voltage from the miniature battery (31);
**characterized in that**
the multilayer ceramic SMD capacitor (10) is placed on the apex of the metal hollow needle (11);
said miniature sensor has sensing surface dimension of 1 × 0.5 mm, and a capacity of the order of ones of micro Farads; and
the metal hollow needle (11) has an outer diameter smaller than 0.5 mm.

## Patentansprüche

1. Das zur punktuellen Schalldruckmessung in Flüssigkeiten und Gasen konfigurierte System enthaltend:
eine Metallhohlnadel (11) mit einer Spitze;
einen Miniatursensor bestehend aus einem SMD-Kondensator (10);
einen am Ende der Metallhohlnadel (11) auf der deren Spitze gegenüberliegenden Seite vorgesehenen Miniaturstecker (14).
ein dünnes Koaxialkabel (20);
einen elektrisch abgeschirmten Adapter (30), bestehend aus:
einem Eingangsanschluss (21);
einem Entkopplungswiderstand (32);
einem Ausgangsentkopplungskondensator (34);
einer BNC-Ausgangsbuchse (35) zum Anschluss an ein je nach Anwendung gewähltes Mess-, Aufzeichnungs- oder Auswertegerät;
eine Miniaturbatterie (31); und
einen Schalter (33)
wobei ein Ende des Ausgangsentkopplungskondensators (34) mit dem Eingangsanschluss (21) und das andere Ende mit der BNC-Ausgangsbuchse (35) verbunden ist;
wobei ein Ende des Ausgangsentkopplungswiderstands (32) mit einem Ende des Ausgangsentkopplungskondensators (34) und das andere Ende mit dem gemeinsamen Pol des Schalters (33) verbunden sind;
wobei ein Pol des Schalters (33) mit dem Pluspol der Miniaturbatterie (31) und der nächste Pol mit der Erdungsklemme verbunden sind;
wobei der Minuspol der Miniaturbatterie (31) geerdet ist, und
wobei ein dünnes Koaxialkabel (20) zum Anschluss an den Miniaturstecker (14) und den Eingangsstecker (21) ist angepasst;
wobei eine Zuleitung des SMD-Kondensators (10) leitend mit der Nadel (11) verbunden ist und die andere Zuleitung des SMD-Kondensators (10) mit dem Draht (12), der durch den Hohlraum der Nadel (11) verläuft, verbunden ist;
wobei die Spitze der Nadel (11), der SMD-Kondensator (10) und die Anschlussdrähte (12) mit einer dünnen, undurchlässigen Elektroisolierschicht (13) beschichtet sind;
wobei das untere Ende der Nadel (11) auf der deren Spitze gegenüberliegenden Seite und der Draht (12) mit dem dünnen Verbindungskoaxialkabel (20) verbunden sind; und
wobei das dünne Verbindungskoaxialkabel (20) zur Übertragung des Signals des Miniatursensors zur weiteren Verarbeitung und zur Versorgung mit der erforderlichen Gleichstromvorspannung aus der Miniaturbatterie (32) vorgesehen ist;
**dadurch gekennzeichnet, dass** ein SMD-Keramik-Vielschicht-Kondensator (10) auf der Spitze der Metallhohlnadel (11) angeordnet ist;
der Miniatursensor über eine Abtastfläche von 1 mm x 0,5 mm und eine Kapazität in der Größenordnung von Mikrofarad-Einheiten verfügt; und
die Metallhohlnadel (11) einen Außendurchmesser kleiner als 0,5 mm hat.

## Revendications

1. Système configuré pour effectuer la détection de la pression acoustique ponctuelle dans les liquides et les gaz comprenant :
une aiguille creuse en métal (11) avec pointe ;
un capteur miniature constitué d'un condensateur SMD (10) ;
un connecteur miniature (14) situé à l'extrémité de l'aiguille creuse métallique (11), du côté opposé à sa pointe.
un câble coaxial fin (20) ;
un adaptateur électriquement blindé (30) comprenant :
un connecteur d'entrée (21) ;
résistance de découplage (32) ;
le condensateur de découplage de sortie (34) ;
un connecteur de sortie BNC (35) pour la connexion à un appareil de mesure, d'enregistrement ou d'évaluation choisi en fonction de l'application utilisée ;
une batterie miniature (31) ; et
un commutateur (33)
une extrémité du condensateur de découplage de sortie (34) étant connectée au connecteur d'entrée (21) et l'autre extrémité étant connectée au connecteur de sortie BNC (35) ;
une extrémité de la résistance de découplage de sortie (32) étant connectée à une extrémité du condensateur de découplage de sortie (34) et l'autre extrémité étant connectée au pôle commun du commutateur (33) ;
un pôle du commutateur (33) étant connecté au pôle positif de la batterie miniature (31) et l'autre pôle étant connecté à la borne de mise à la terre ;
la borne négative de la batterie miniature (31) étant mise à la terre, et
un câble coaxial fin (20) est modifié pour être connecté au connecteur miniature (14) et au connecteur d'entrée (21);
un fil du condensateur SMD (10) étant connecté de manière conductrice à l'aiguille (11) et l'autre fil du condensateur SMD (10) étant connecté au conducteur (12) qui passe à travers la cavité de l'aiguille (11) ;
la pointe de l'aiguille (11), le condensateur SMD (10) et les conducteurs de connexion (12) étant recouverts d'une fine couche d'isolation électrique imperméable (13) ;
l'extrémité inférieure de l'aiguille (11) du côté opposé à son sommet et le conducteur (12) étant connectés au câble d'interconnexion coaxial fin (20) ; et
le câble d'interconnexion coaxial fin (20) étant configuré pour transporter le signal du capteur miniature en vue d'un traitement ultérieur et fournir la tension de polarisation continue nécessaire à partir de la batterie miniature (32) ;
**caractérisé en ce que** le condensateur en céramique multicouche SMD (10) est placé sur la pointe de l'aiguille creuse en métal (11) ;
le capteur miniature a une surface de détection de 1 mm x 0,5 mm et une capacité de l'ordre des unités de microfarads ; et
l'aiguille creuse en métal (11) a un diamètre extérieur inférieur à 0,5 mm.
